# EUROPEAN PATENT APPLICATION

(11) **EP 4 383 321 A1**
(43) Date of publication of application: **12.06.2024**
(21) Application number: 22211797.0
(22) Date of filing: 06.12.2022
(51) Int. Cl.: H01L 21/683, H05K 3/04

(54) **METHOD AND DEVICE FOR DEPOSITING COMPONENTS ON A SUBSTRATE**

(71) Applicant: Nederlandse Organisatie voor toegepast-natuurwetenschappelijk Onderzoek TNO, 2595 DA 's-Gravenhage (NL)
(72) Inventor: HENDRIKS, Rob Jacob, DA 's-Gravenhage (NL); KOLDEWEIJ, Robin Bernardus Johannes, DA 's-Gravenhage (NL)
(74) Representative: V.O.

(57) **Abstract**

A deposition device (1) is provided for depositing components (CMP) on a substrate (STR). The deposition device (1) comprises a substrate holder (2), a component carrier (3), a power supply (4) and a support module (5) for supporting the component carrier (3). The substrate holder (2) has a substrate support surface (2s) for holding the substrate (STR). The component carrier (3), which is supported by the support module has a component carrier surface (3s) facing the substrate support surface (2s) for carrying the components to be deposited on the substrate. The component carrier (3) comprises a resistive heater layer (31) for thermally inducing a deformation of the component carrier (3) to move the component carrier surface (3s) towards the substrate support surface (2s). The power supply (4) is configured to generate a deflection pulse (Pd), being an electric power pulse to the resistive heater layer (31) for said thermally inducing a deformation. Also a corresponding deposition method is provided.

## Description

### BACKGROUND

The present application pertains to a method for depositing components on a substrate.

The present application further pertains to a device for depositing components on a substrate.

Mass-transfer of small components is one of the most difficult problems to be solved in order to reduce production costs. For example, in the production process of microLED displays millions of chips have to be placed in the order of minutes to meet the demand and reduce the production cost. Current pick & place machines are not capable of reaching these kind of throughputs, nor can they handle these microscopic components. Accordingly, there is a need for means that facilitate a mass transfer of small components.

### SUMMARY

According to a first aspect of the present disclosure, an improved deposition device for depositing components on a substrate is provided.

According to a second aspect of the present disclosure, an improved deposition method for depositing components on a substrate is provided.

The improved deposition device according to the first aspect comprises a substrate holder, a component carrier, a power supply and a support module.

The substrate holder is provided with a substrate support surface for holding the substrate. The component carrier has a component carrier surface facing the substrate support surface for carrying the components to be deposited on the substrate. The component carrier comprises a resistive heater layer for inducing a thermal expansion in the component carrier to move the component carrier surface towards the substrate support surface.

The power supply is configured to generate a deflection pulse, being an electric power pulse to the resistive heater layer to provide a heat flux for inducing the thermal expansion.

The support module is configured for supporting the component carrier. In addition it may serve to electrically connect the power supply to the resistive heater layer.

In some embodiments the support module constrains the component carrier at laterally opposite sides. Even if the component carrier has a substantially uniform thermal expansion coefficient throughout its depth, it will tend to flex with its component carrier surface towards the substrate support surface with the substrate thereon, as the support module would block a deformation in the contrary direction. In some examples the support module has a slightly convex surface to support the component carrier when it is at room temperature.

In some embodiments, the component carrier has an first layer with a relatively low thermal expansion coefficient at a side closer to the support module and a second layer with a relatively high thermal expansion coefficient at a side closer to the substrate holder. This enhances a thermally induced flexure of the component carrier. Even if the component carrier is fixed to the support module at only one side, it can be flexed with its component carrier surface towards the substrate holder by a heat flux from the resistive heater layer. It is noted that this can be achieved also with a one-side mounted component carrier having a single layer or multiple layers with approximately the same thermal expansion coefficient provided that a temperature gradient is induced in the thickness direction of the component carrier. It is an advantage of the latter embodiment that the component carrier assumes a flat shape once the temperature gradient in its thickness direction is reduced to zero, even if it is not yet fully cooled down.

In summary, the resistive heater layer serves to thermally induce a deformation of the component carrier so that the component carrier surface having the components thereon is moved towards the substrate holder with the substrate. The resistive heater layer may however additionally serve for thermally processing materials in thermal contact with the component carrier surface. Examples thereof will be described later in more detail. Considering this, an embodiment of the deposition device is provided wherein the component carrier comprises a thermally insulating layer at a side of the resistive heater layer facing away from the component carrier surface. The thermally insulating layer does not affect a flow of heat from the resistive heater layer to the component carrier surface but it delays a heat flow in the opposite direction. As a result the thermally induced deformation of the component carrier thermally deformable layer is delayed as compared to the situation wherein a thermally insulating layer is absent. This can be used to control a timing of the thermal induced deformation of the component carrier relative to the timing of the thermal processing. The larger the thickness of the thermally insulating layer, the larger the delay in time. Ceramic materials like siliconoxide, siliconnitride, aluminumoxide are particularly suitable to form a thermally insulating layer as they are highly heat resistant and effectively reduce a flow of heat. Dependent on the required timing a thickness of a thermally insulating layer may be selected for example from a range of about 0.1 micron to about 10 micron.

In some embodiments of the deposition device the component carrier comprises a thermally insulating layer at a side supported by the support module. Also this measure is favorable for controlling a timing of thermal processing relative to a timing of thermally inducing a deformation of the component carrier.

Optionally a support surface of the support module is provided with evacuation channels to be evacuated, so as to bias the component carrier against the support surface. When no supply power is supplied to the resistive heater layer and the resistive heater layer is at a relatively low temperature, the difference between the atmospheric pressure on the component carrier surface and the reduced pressure on the opposite surface of the component carrier biases the component carrier against the support surface. When power is supplied to the resistive heater layer the component carrier bends and overcomes the biasing force. In an example thereof the support module comprises a peripheral section wherein the evacuation channels are to be evacuated at a pressure lower than a pressure prevailing in the evacuation channels in a central section enclosed by the peripheral section. In this example the difference between the atmospheric pressure on the component carrier surface and the further reduced pressure on the opposite surface of the component carrier prevailing in the peripheral section forces the component carrier at its periphery against the support surface even while a central portion of the component carrier bends towards the substrate.

In some embodiments the support module comprises electric contact pins in its peripheral section that are configured to cooperate with electric contact terminals of the component carrier in a peripheral section thereof. Upon arranging the component carrier on the support module the difference between the atmospheric pressure on the component carrier surface and the further reduced pressure on the opposite surface of the component carrier prevailing in the peripheral section forces electric contact terminals of the component carrier against the electric contact pins of the support module, therewith providing for a secure electric connection.

In some embodiments of the deposition device the substrate holder has a concave substrate support surface with evacuation channels to be evacuated, so as to bias the substrate against the concave substrate support surface. This measure is based on the consideration that the component carrier upon deflecting bows into a convex shape. When the substrate support surface has complementary concave shape, it is ensured that a contact time between the component carrier surface and the components thereon with the substrate on the substrate support surface is substantially uniform over the entire area. This is in particular relevant for thermal processing, e.g. soldering components on the substrate surface.

As noted above, in some embodiments the resistive heater layer not only serves to thermally induce the deflection of the component carrier but also to perform a thermal processing operation.

For example, in an embodiment of the deposition device the power supply is configured to generate a gluing pulse, being a subsequent electric power pulse to the resistive heater layer to further increase a temperature thereof for activating an adhesive on the component carrier surface.

In another example, already referred to above, the power supply is configured to generate a soldering pulse, being a subsequent electric power pulse to the resistive heater layer to further increase a temperature thereof for melting a solder with which the component is to be connected to the substrate.

In again another example, the power supply is further configured to generate a decomposition pulse, being an electric power pulse which has a duration shorter than the deflection pulse and a power exceeding that of the deflection pulse to decompose an adhesive with which the components are adhered to the component carrier surface. Therewith the components can be released from the component carrier surface even if the adhesive strength of the adhesive used is relatively high. The decomposition pulse may for example be provided subsequent to a soldering pulse to release the component from the component carrier once it is soldered.

In an embodiment the resistive heater layer comprises a plurality of individually addressable sections for heating respective areal portions of the component carrier surface. Therewith components can be transferred in a selective manner. First the deflection pulse is simultaneously supplied to all sections of the resistive heater layer. Therewith the component carrier surface with the components thereon is pressed against the surface of the target substrate thereon. Then a soldering pulse and a decomposition pulse can be applied to a subset of addressable sections corresponding to the locations on the component carrier surface where the selected components to be transferred are present. Therewith, these selected components are bonded to the substrate and the adhesive with which they were temporarily adhered to the component carrier is decomposed. Upon cooling down the selected components remain bonded to the target substrate and the remaining components are retracted by the component carrier surface to which they are still adhered. As the temperature distribution of the component carrier can be controlled in a more fine grained manner this approach may also be suitable in case the substrate holder has a flat substrate support surface.

The improved method according to the second aspect comprises:
providing a component carrier, having a component carrier surface;
adhering components on the component carrier surface;
arranging the substrate on a substrate support surface of a substrate holder, with the substrate support surface facing the component carrier surface;
resistively heating the component carrier to induce a thermal expansion therein to move the component carrier surface towards the substrate support surface;
cooling or allowing the component carrier to cool to cause the component carrier to move away from the from the substrate holder.

In an embodiment of the improved method the components are adhered to the component carrier surface of the component carrier using a specimen of a thermally curable/processable/sensitive adhesive. Examples thereof are a photoresist (positive or negative) or a low melting point thermoplastic polymer (hotmelt) such as PVP, PPC.

The component carrier is then resistively heated with a deflection pulse to thermally induce a deformation thereof to cause the component carrier to bend with its component carrier surface towards a supply substrate with components thereon.

Subsequently the component carrier is resistively heated with a gluing pulse that causes a further temperature increase for thermally processing the adhesive for adhering the components to the surface of the component carrier.

In some embodiments of the method, subsequent to resistively heating the component carrier to cause the component carrier to bend with its component carrier surface towards the substrate support surface, the component carrier is restively heated further to increase its temperature further to form a liquid phase for bonding the components to bond pads on the substrate. In an example of these embodiments, the component carrier surface is resistively heated further to increase its temperature to decompose an adhesive used for adhering the components on the component carrier surface.

The improved method can also be used to remove existing soldered components (e.g. damaged, non-functional) from the substrate. This can be achieved with the following embodiment.

Therein a further adhesive is applied to a surface of the component to be removed from the substrate or on an area of the component carrier surface facing the component to be removed. For this purpose the further adhesive used herewith has a melting temperature exceeding that of an adhesive and/or solder with which the component to be removed is bonded to the substrate.

Subsequently a deflection pulse is provided to the resistive heating layer to thermally induce a deformation of the component carrier so that the component carrier surface is moved towards the component to be removed. In addition the resistive heater layer is powered to provide a transfer of heat that causes melting of the adhesive and/or solder with which the component to be removed is bonded to the substrate. Also the further adhesive melts therewith.

After the supplying of electric power is stopped the further adhesive cools down and cures. The component carrier surface with the component adhered thereto with the cured further adhesive retracts from the substrate before a curing of the adhesive and/or solidifying of the solder with which the component was bonded to the substrate could occur.

### BRIEF DESCRIPTION OF THE DRAWINGS

These and other aspects of the present disclosure are described in more detail with respect to the drawings. Therein:
FIG. 1 schematically shows an embodiment of an improved deposition device for depositing components on a substrate;
FIG. 2A and 2B shows two operational states of a component carrier used in the improved deposition device;
FIG. 3 shows a first exemplary component carrier;
FIG. 4 shows a second exemplary component carrier;
FIG. 4A shows a third exemplary component carrier;
FIG. 5A - 5E shows subsequent steps of an embodiment of the improved method;
FIG. 6A and 6B show further aspects of said embodiment;
FIG. 7 shows a step in an alternative embodiment of the improved method.

### DETAILED DESCRIPTION OF EMBODIMENTS

Like reference symbols in the various drawings indicate like elements unless otherwise indicated.

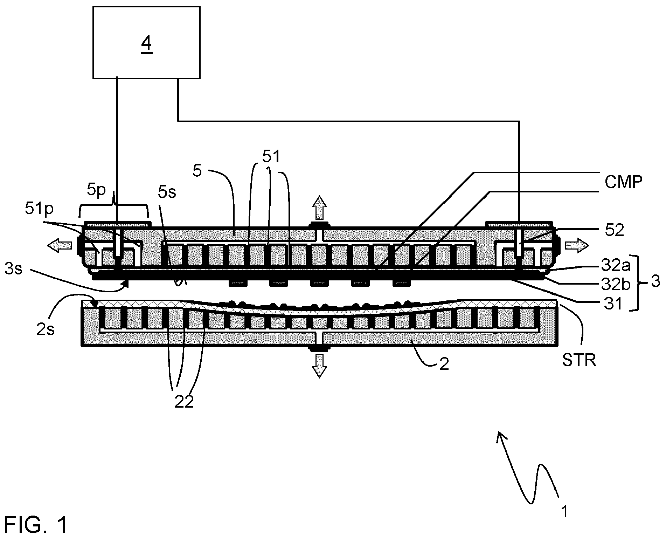

FIG. 1 schematically shows an embodiment of an improved deposition device 1 for depositing components CMP on a substrate STR. The device comprises a substrate holder 2, a component carrier 3, a power supply 4 and a support module 5.

The substrate holder 2 has a substrate support surface 2s for holding the substrate STR. The component carrier 3 has a component carrier surface 3s facing the substrate support surface 2s for carrying the components CMP to be deposited on the substrate. The component carrier 3, which is supported by the support module 5 comprises a resistive heater layer 31.

The power supply 4 is configured to generate an electric power pulse, also denoted herein as a deflection pulse Pd, to the resistive heater layer 31. The deflection pulse causes the resistive heater layer 31 to generate heat with which it thermally induces a deformation of the component carrier 3 so that the component carrier surface 3s with the components CMP thereon move towards the substrate STR on the substrate support surface 2s.

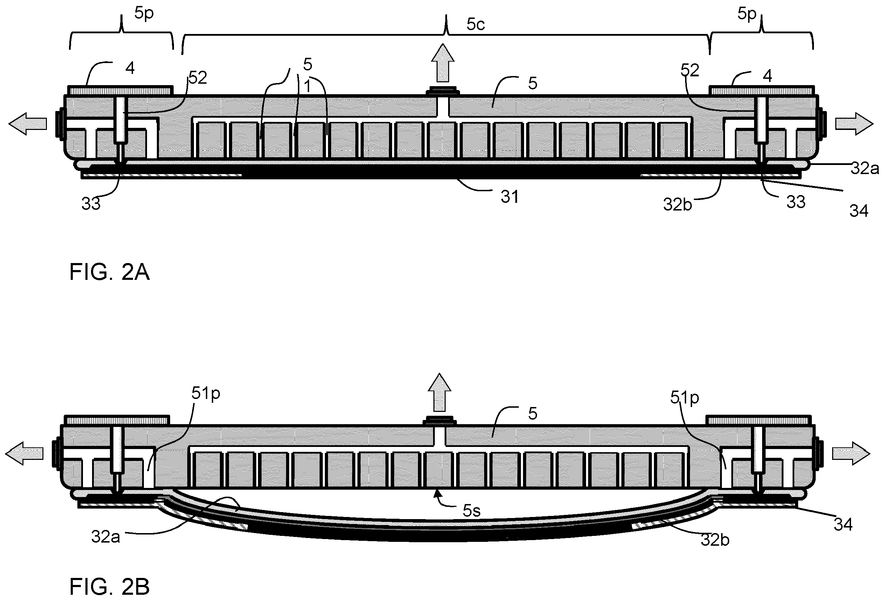

FIG. 2A and 2B shows the support module 5 with the component carrier 3 in two operational states. In the first operational state shown in FIG. 2A, the component carrier 3 is at a low temperature. In the second operational state shown in FIG. 2B, the component carrier 3 is deformed due to a high temperature.

In the embodiment shown the component carrier 3 comprises at least a first layer 32a with a first thermal expansion coefficient at side closer to the support module 5 and a second layer 32b with a second thermal expansion coefficient greater than the first thermal expansion coefficient at side closer to the substrate holder 2. In this example, the at least a first layer 32a is a wafer 32a and the at least a second layer 32b comprises one or more busbars embedded in the wafer. The wafer in this example is a silicon wafer having a thermal expansion coefficient of 3.1 ppm/K and the busbars are of copper, having a thermal expansion coefficient of 17 ppm/K. When the power supply 4 supplies a deflection pulse to the resistive heater layer 31 the heat induced therein causes the busbars in the second layer 32b to expand. Also the first layer 32a expands, but to a lesser extent. As a result the component carrier 3 deflects, so that its component carrier surface 3s with the components CMP thereon moves towards the substrate thereon STR on the substrate support surface 2s. It is noted that this effect can also be achieved if the component carrier 3 does not have layers with a mutually different expansion coefficient, provided that the component carrier 3 is fixed to the support module 5 at laterally opposite edges. In that case the desired deformation still occurs due to the integral thermal expansion of the component carrier 3. As the component carrier 3 cannot flex in a direction towards the support module 5 it will flex with its component carrier surface 3s towards the substrate STR. Another option to achieve the desired thermally induced deformation is to create a temperature gradient in the thickness direction of the component carrier 3, i.e. such that a temperature of the component carrier 3 decreases towards the support module 5. Even if the component carrier 3 has a uniform thermal expansion coefficient, the side facing the substrate, being subjected to a higher temperature expands more than the side facing the support module 5 having a lower temperature, so that the component carrier surface 3s moves in the direction of the substrate. In the embodiment shown in FIG. 1, the busbars in the second layer 32b provide for an electric connection between the power supply 4 and the resistive heater layer 31.

In the embodiment in FIG. 1 the support module 5 supports the component carrier 3 at laterally opposite sides. As shown in FIG. 1, the support module 5 comprises a peripheral section 5p with evacuation channels 51p. During operation the evacuation channels 51p are evacuated. At the opposite edge the support module 5 comprises a similar peripheral section. The difference between the atmospheric pressure on the component carrier surface 3s and the pressure on the opposite surface of the component carrier prevailing in the peripheral section forces the component carrier at its periphery against the support surface.

Also a central section of the support surface 5s of the support module 5 is provided with evacuation channels 51 to be evacuated, so as to bias the component carrier 3 against the support surface 5s. When no supply power is supplied to the resistive heater layer and the resistive heater layer is at a relatively low temperature, the difference between the atmospheric pressure on the component carrier surface and the reduced pressure on the opposite surface of the component carrier biases the component carrier against the support surface. When power is supplied to the resistive heater layer the component carrier bends and overcomes the biasing force. Typically the pressure prevailing in the evacuation channels 51p at the periphery of the support module 5 is lower than the pressure prevailing in the evacuation channels 51 in a central section enclosed by the peripheral section. Even when a central portion of the component carrier is deflected by a thermally induced deformation, the component carrier 3 is still firmly pressed at its edges (or edge, in case it is circular) against the periphery of the support module 5.

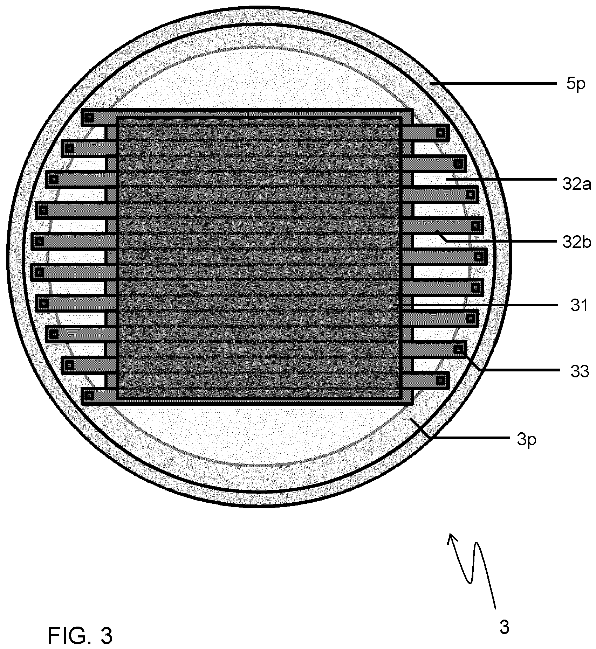

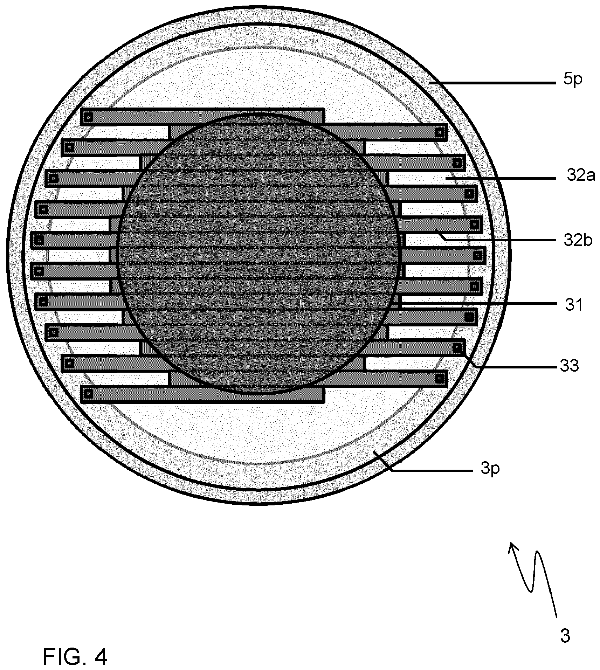

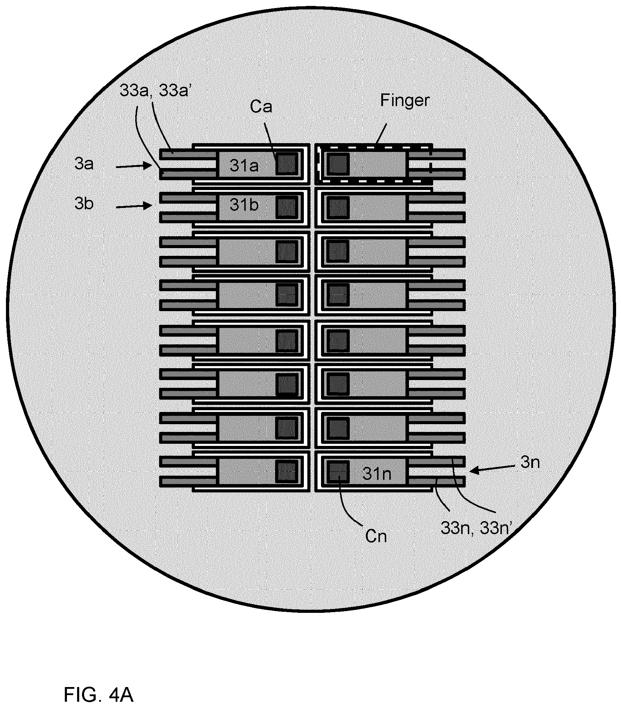

In the embodiment shown in FIG. 1, the support module 5 comprises electric contact pins 52 in its peripheral section 5p that are configured to cooperate with electric contact terminals 33 (See FIG. 3 or 4) of the component carrier 3 in a peripheral section 3p (See FIG. 3 or 4) thereof. Upon arranging the component carrier 3 on the support module 5 the difference between the atmospheric pressure on the component carrier surface and the further reduced pressure on the opposite surface of the component carrier prevailing in the peripheral section forces electric contact terminals of the component carrier against the electric contact pins 52 of the support module. Therewith a firm electric and mechanical connection is provided between the support module 5 and the component carrier 3. If desired, the electric and mechanical connection can be cancelled by removing the vacuum in the evacuation channels 51 and 51p.

In the embodiment shown in FIG. 1, the substrate holder 2 has a concave substrate support surface 2s with evacuation channels 22 to be evacuated, so as to bias the substrate STR against the concave substrate support surface 2s. Therewith it is ensured that a contact time between the component carrier surface 3s and the components CMP thereon with the substrate STR on the substrate support surface 2s is substantially uniform over the entire area. This is in particular relevant for thermal processing, e.g. soldering components on the substrate surface. The difference between the pressure in the environment and the relatively low pressure prevailing in the evacuation channels of the concave substrate support surface cause the substrate to assume the curvature of the concave substrate support surface so that that the thermal contact time is similar over the entire area.

FIG. 3 shows aspects of a first example of a component carrier 3 in an embodiment of the deposition device 1. In the embodiment shown in FIG. 3, the component carrier 3 has a square shaped resistive heater layer 31 which is electrically connected to the busbars in the second layer 32b having contact pins 33 to provide for an electric connection with the electric contact pins (not shown) in the peripheral section 5p of the support module.

FIG. 4 shows another embodiment, wherein the component carrier 3 has a circular shaped resistive heater layer 31.

FIG. 4A shows a still further embodiment, wherein the component carrier has carrier fingers 3a, 3b,...3n that are laterally separated from each other by a gap. The carrier fingers are fixed at a first end and have a free second end opposite the first end, Each carrier finger 3a, 3b,...3n has a respective heater layer portion 31a, 31b,...31n, and a respective pair of contact terminals 33a, 33a'....33n, 33n' at its first end where it is fixed. Therewith the carrier fingers can be heated independent from each other in order to flex them and therewith to transfer a respective component Ca,...,Cn, carried at their second end, towards the target surface. As in other embodiments, flexure of a component carrier finger may be the result of a differences in thermal expansion of layers therein. Alternatively, or additionally flexure can result from a thermal gradient in a carrier finger.

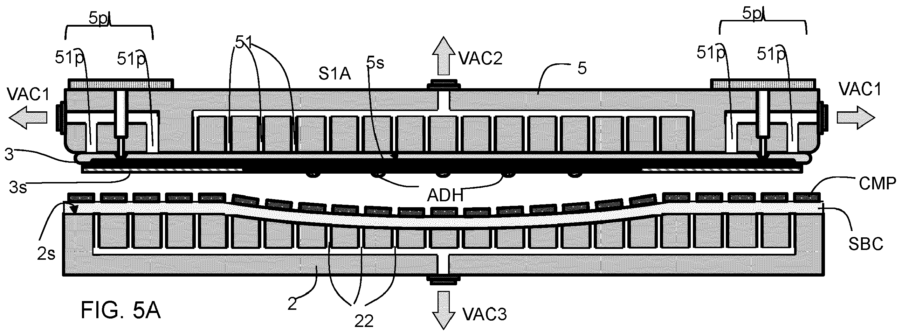

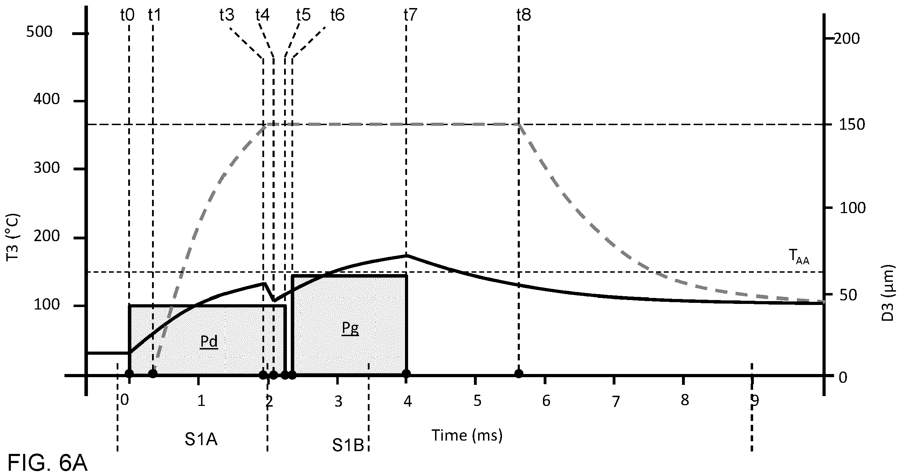

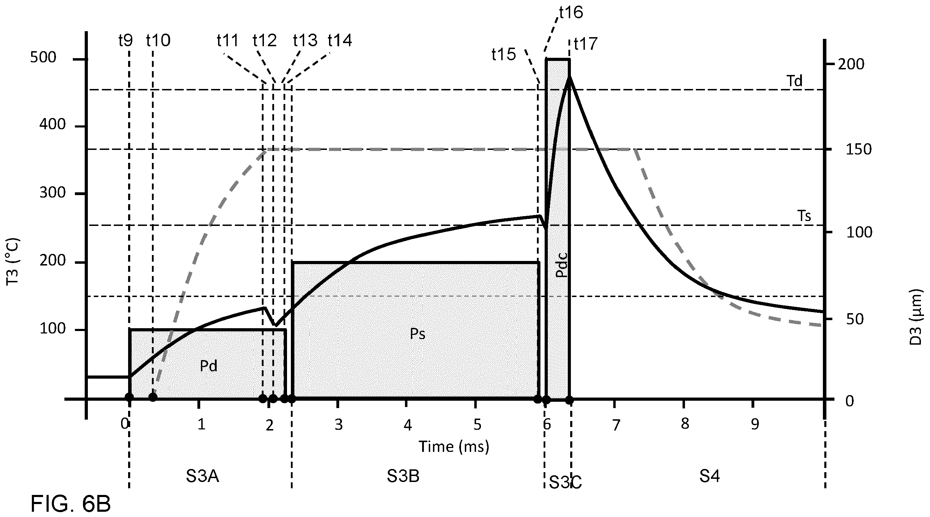

FIG. 5A - 5E and FIG. 6A, 6B show an embodiment of an improved method of depositing components CMP on a substrate STR. Therein FIG. 5A - 5E show operational states of the component carrier 3 and FIG. 6A and 6B show the temperature T3 (solid line) and the deflection D3 (broken line) of the component carrier 3 as a function of time during performance of the method.

As shown in FIG. 5A, a component carrier 3, having a component carrier surface 3s is provided and components CMP to be deposited are adhered thereto. In this example, for each component to be adhered a specimen of a thermally curable/processable/sensitive adhesive ADH is applied to the component carrier surface 3s of the component carrier 3. As shown in FIG. 5A, the component carrier 3 is supported by the support module 5. The component carrier 3 is therewith fixed to the support module 5 by the pressure difference between the environmental pressure and the pressure VAC1 applied in the evacuation channels 51p at the periphery 5p of the support module 5. Also the evacuation channels 51 are evacuated, albeit to a pressure VAC2 in between the pressure VAC1 and the environmental pressure, so as to bias the component carrier 3 against the surface 5s of the support module. FIG. 5A also shows that a substrate holder 2 having a temporary substrate SBC with components CMP is positioned in front of the component carrier surface 3s. It is also shown that the temporary substrate SBC is pressed to the concave surface 2s of the substrate holder 2 by the difference between the environmental pressure and a reduced pressure VAC3 prevailing in the evacuation channels 22 in the substrate holder 2. The heating rate during the deflection step S1A determines the speed at which the component carrier surface 3s approaches the components CMP on the temporary substrate SBC. In the example shown, the component carrier surface 3s is deformed with 150 µm in 2 milliseconds, which corresponds to a speed of about 0.075 m/s. It is also possible increase the speed by a corresponding increase in the power supplied during the deflection step S1A. Care should be taken however that the deflection speed is not too high. For example when performing this step in a few microseconds the deflection speed may become too high and could cause damage.

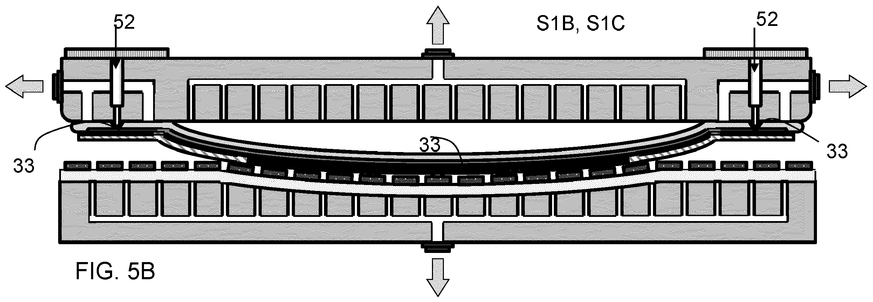

In a subsequent step S1B shown in FIG. 5B the power supply (not shown) provides a deflection pulse Pd (from t0 to t5, see FIG. 6) to the contact pins 52. Due to the pressure difference caused by the evacuation pressure VAC1 in the peripheral section a firm electric connection is achieved between the electric contact pins 52 and the electric contact terminals 33 in the peripheral section 3p of the component carrier 3. As a result the resistive heater layer 31 resistively heats the component carrier. At a point in time t1 the thermal stress induced therewith in the component carrier 3 is strong enough to deflect the component carrier away from the evacuated surface 5s of the of the support module 5. The component carrier 3 however remains firmly pressed against the support module 5 at its periphery, due to the stronger pressure difference induced by the evacuation pressure VAC 1. At point in time t3 the component carrier 3 is deflected to that extent that it is pressed with its component carrier surface 3s towards the components CMP on the supply substrate SBC. As shown in FIG. 6, at that point in time the temperature T3 of the component carrier 3 may temporarily decrease.

As shown in FIG. 6, the power supply subsequently provides a glueing pulse Pg (from t6 to t7). Therewith the component carrier 3 is resistively heated SIC) to a higher temperature, exceeding a required temperature T_{AA} to thermally activate the adhesive ADH so as to adhere the components CMP to the surface 3s of the component carrier 3. In an example the adhesive ADH is a photoresist (positive or negative). In an example the photoresist comprises a photoacid generator. Therewith an activation temperature of the adhesive can be modified within a large range to a desired value for a particular application by activating the photoacid generator to a mutually different extent as determined by a duration or intensity of irradiation with photo radiation (e.g. UV-radiation). Alternatively a low melting point thermoplastic polymer (hotmelt), PVP, PPC may be used as the adhesive. The temporary substrate SBC usually is colder than the component carrier 3 at the time of contacting, and therewith may act as a heat sink. This should be taken into account, either by providing more energy during the gluing pulse or by pre-heating the temporary substrate SBC. During the cool down period, the adhesion between the component carrier 3 and the components CMP should be higher than the adhesion between the components CMP and the temporary substrate SBC so that the components CMP are pulled from the temporary substrate SBC. When the component carrier 3 retracts, it can be positioned and aligned with bond pads on the target substrate.

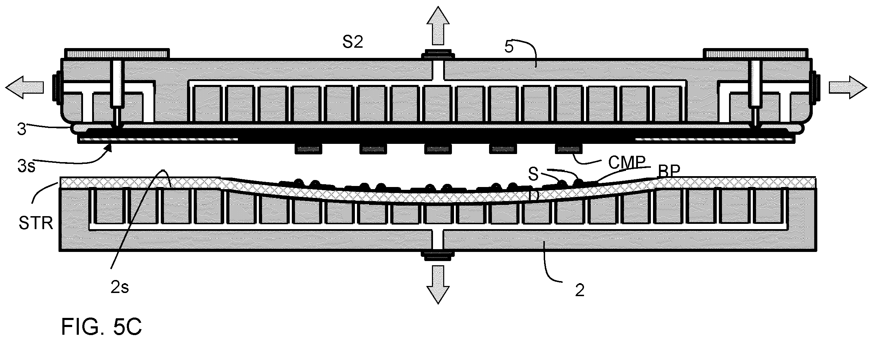

In the situation shown in FIG. 5C the target substrate STR is arranged (S2 on the substrate support surface 2s of a substrate holder 2. The substrate support surface 2s with the substrate STR thereon faces the component carrier surface 3s. As shown in FIG. 5C, the substrate thereon STR is provided with solder SD on bond pads BP.

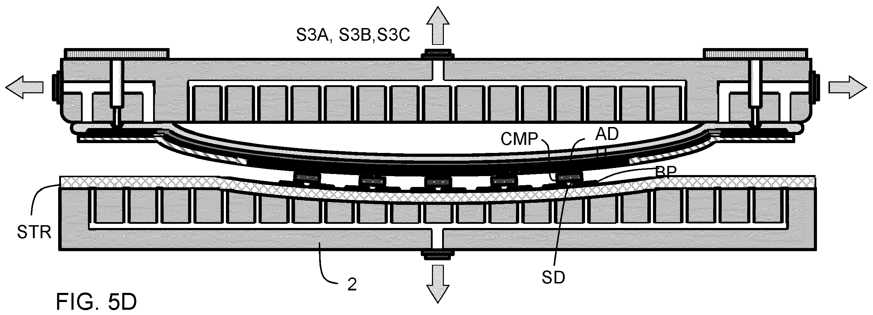

In a subsequent step S3A, shown in FIG. 5D and FIG. 6B, again a deflection pulse Pd is applied between t9 and t13, to resistively heat the component carrier 3 to therewith induce a thermal expansion so that the component carrier surface 3s moves towards the substrate support surface.

Subsequent to the step S3A, in step S3B, while the component carrier 3 is still in its deflected state, the power supply provides a solder pulse Ps (from t4 to t15). Therewith the component carrier 3 is restively heated to a further increase temperature that exceeds a soldering temperature T2 so as to form a liquid phase for bonding the components CMP to the bond pads (PB) on the substrate STR. The components CMP therewith are being assembled on the bond pads PB, for example through soldering or eutectic bonding. Alternatively, the electrical and mechanical connection between the components CMP and the bond pads BP may be achieved by curing a precursor of an electrically conductive adhesive in this step. It is noted that the interconnect material, being a solder or an electrically conductive adhesive can also already be on the components CMP themselves. The pressure applied by the deflected component carrier 3 together with the adhesive ADH, helps to keep the components CMP in place while being soldered or adhered to the substrate STR. In this way the components CMP, e.g. microLED display elements, can be assembled with high precision in all six degrees of freedom to ensure a good image quality.

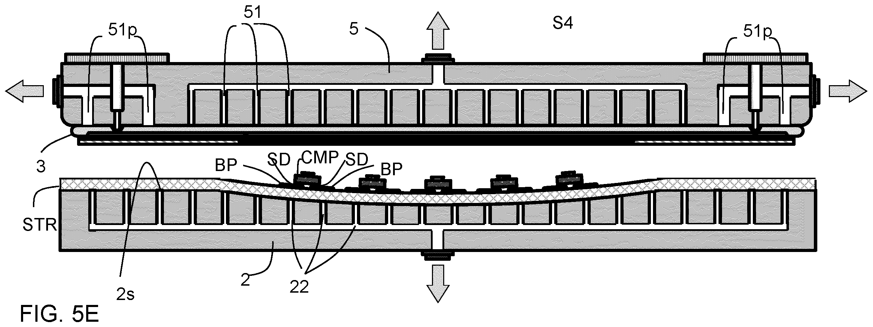

In the embodiment shown in FIG. 6B, the power supply subsequently provides a decomposition pulse Pdc in a step S3C. Therewith the component carrier surface is resistively heated further to increase its temperature to a value that exceeds a decomposition temperature of the adhesive (ADH) with which the components CMP are still adhered to the component carrier surface 3s. Subsequent to providing the decomposition pulse Pdc the adhesive ADH is decomposed, so that during cooldown and retraction in step S3D the component carrier 3 is released from the components CMP as shown in FIG. 5E. The decomposition pulse Pdc could also be postponed until a solder connection with the substrate thereon STR has been solidified, provided that the component carrier 3 is still sufficiently deflected to exert a pressure on the components. It is noted that the decomposition pulse Pdc can have a relatively short duration as only the adhesive, which is in direct thermal contact with the component carrier surface 3s needs to be heated.

The decomposition pulse may also be provided subsequent to the soldering pulse to release the component from the component carrier once it is soldered.

Once the substrate STR is sufficiently cooled down, it can be released from the substrate support surface 2s by removing the vacuum in the evacuation channels 22.

If desired, also the vacuum in the evacuation channels 51 and 51p can removed, so that the component carrier 3 can be taken from the support module 5.

It may be contemplated to perform the steps of deflection, soldering and decomposition with a single pulse. In this case the single pulse of power (having a relatively high power value) that is supplied to the resistive heater layer 31 of the component carrier 3 not only causes the component carrier 3 to deflect but provides enough energy to process the interconnect material (e.g. a solder or precursor of an electrically conducting adhesive) and to decompose the adhesive with which the components CMP are temporarily adhered to the component carrier surface 3s. Subsequent to having supplied the single pulse the component carrier 3 cools down and retracts, leaving the components CMP bonded to the target substrate thereon STR. This approach is preferred when the components to be transferred are relatively thick for example >100 µm, and their thermal conductivity is relatively low, e.g. < 1 W/mK.

The improved method and device provide a cost efficient solution to transfer components to a target substrate. The thermal deformation with which the component carrier 3 is deformed so as to deflect its component carrier surface 3s towards the substrate thereon STR can be performed very fast and in a more controllable manner as compared to what would be achievable with an electromagnetic actuator, and is cost efficient.

Still further, the improved method and device render it possible to integrate various production steps including pick&place, thermal curing and releasing in a single system. This reduces the complexity and significantly increases the throughput of component assembly. The only throughput limitation comes from aligning the substrate holder 2, the substrate and the component carrier 3. With an alignment time of about 0.5 seconds, the improved device and method can fully assemble more than 1,000,000 micro components per seconds. Therewith the per-component alignment time is negligible.

It is also noted that with the additional pressure exerted by the component carrier 3 on the components during the soldering (or curing) step it is ensured that the transferred components are perfectly level with the target substrate STR.

Provided that the adhesive with which the components are temporarily adhered to the component carrier surface 3s, the component carrier 3 can be used continuously. This is in sharp contrast to PDMS stamps, which tend to wear out and lead to yield problems.

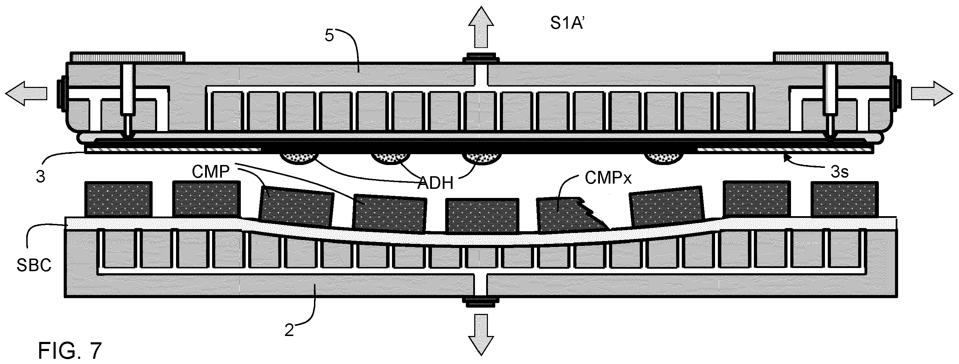

If it is detected that a component CMPx provided on the temporary substrate SBC does not meet quality requirements, it can be easily prevented that this component is adhered to the component carrier 3 in an alternative step S1A' as shown in FIG. 7. In this case, no adhesive is provided on the location of the component carrier surface 3s the defect component CMPx. In that case, when proceeding with the steps shown in FIG. 5B and 5C, the defect component CMPx remains on the temporary substrate SBC while the remaining components are transferred.

Should it be the case that a component that is already bonded to a target surface appears to be malfunctioning, it can be removed and replaced with the improved device as follows. In this case a droplet of a thermal adhesive is deposited on the component carrier surface 3s opposite the malfunctioning component and by application of a deflection pulse the component carrier surface 3s with the thermal adhesive thereon is pressed against the malfunctioning component. Subsequently a soldering pulse is applied that causes the solder with which the defect component is bonded to the substrate to melt. The thermal adhesive should have a higher decomposition temperature than the melting point of the solder that bonds the component to the substrate. An additional actuator may be provided that retracts the support module 5 with the component carrier 3 having the malfunctioning component adhered thereon before the solder starts to solidify again.

Subsequently, the improved device can be used to bond a replacement component to the target substrate. This can be achieved by selectively picking up a replacement component from a temporary substrate. This can be done in a manner similar as shown in FIG. 7. However, in this case the step S1A' is used to selectively transfer that replacement component to the component carrier 3. Subsequently the replacement component can be transferred to the empty location of the substrate thereon STR with the steps shown in FIG. 5C, 5D and 5E.

In the claims the word "comprising" does not exclude other elements or steps, and the indefinite article "a" or "an" does not exclude a plurality. A single component or other unit may fulfill the functions of several items recited in the claims. The mere fact that certain measures are recited in mutually different claims does not indicate that a combination of these measures cannot be used to advantage. Any reference signs in the claims should not be construed as limiting the scope.

## Claims

1. A deposition device (1) for depositing components (CMP) on a substrate (STR), comprising:
a substrate holder (2) with a substrate support surface (2s) for holding the substrate (STR);
a component carrier (3) having a component carrier surface (3s) facing the substrate support surface (2s) for carrying the components to be deposited on the substrate, wherein the component carrier (3) comprises a resistive heater layer (31) for thermally inducing a deformation of the component carrier (3) to move the component carrier surface (3s) towards the substrate support surface (2s);
a power supply (4) configured to generate a deflection pulse (Pd), being an electric power pulse to the resistive heater layer (31) for said thermally inducing a deformation;
a support module (5) for supporting the component carrier (3).

2. The deposition device (1) according to claim 1, wherein the component carrier (3) comprises at least a first layer (32a) with a first thermal expansion coefficient at side closer to the support module (5) and a second layer (32b) with a second thermal expansion coefficient greater than the first thermal expansion coefficient at side closer to the substrate holder (2).

3. The deposition device (1) according to claim 2, wherein the at least a first layer (32a) is a wafer (32a) and the at least a second layer (32b) comprises one or more busbars (32b) embedded in the wafer.

4. The deposition device (1) according to claim 1, 2 or 3, wherein the support module (5) supports the component carrier (3) at a single lateral side.

5. The deposition device (1) according to claim 1, 2 or 3, wherein the support module (5) constrains the component carrier (3) at laterally opposite sides.

6. The deposition device, wherein the component carrier (3) at a side supported by the support module (5) comprises a thermally insulating layer.

7. The deposition device according to any of the preceding claims, wherein the component carrier comprises a thermally insulating layer at a side of the resistive heater layer facing away from the component carrier surface.

8. The deposition device (1) according to any of the preceding claims, wherein in a peripheral section (5p) of the support module (5) a support surface (5s) is provided with evacuation channels (51p) to be evacuated at a pressure lower than an environmental pressure.

9. The deposition device (1) according to claim 8, wherein the support module (5) comprises electric contact pins (52) in its peripheral section (5p) that are configured to cooperate with electric contact terminals (33) of the component carrier (3) in a peripheral section (3p) thereof.

10. The deposition device (1) according to any of the preceding claims, wherein a central section of the support surface (5s) of the support module (5) is provided with evacuation channels (51) to be evacuated at a pressure lower than an environmental pressure, but higher than the pressure with which the evacuation channels (51p) in the peripheral section (5p) are evacuated, so as to bias the component carrier (3) against the support surface (5s).

11. The deposition device (1) according to any of the preceding claims, wherein the substrate holder (2) has a concave substrate support surface (2s) with evacuation channels (22) to be evacuated, so as to bias the substrate (STR) against the concave substrate support surface (2s).

12. The deposition device (1) according to any of the preceding claims wherein the power supply (4) is configured to generate a gluing pulse (Pg), being a subsequent electric power pulse to the resistive heater layer (31) to further increase a temperature thereof for activating an adhesive (ADH) on the component carrier surface.

13. The deposition device (1) according to any of the preceding claims, wherein the power supply (4) is configured to generate a soldering pulse (Ps), being a subsequent electric power pulse to the resistive heater layer (31) to further increase a temperature thereof for processing an interconnection substance such as a solder or a precursor of an electrically conductive adhesive with which the component (CMP) is to be connected to the substrate (STR).

14. The deposition device (1) according to any of the preceding claims, wherein the power supply (4) is further configured to generate a decomposition pulse (Pdc), being an electric power pulse which has a duration shorter than the deflection pulse and a power exceeding that of the deflection pulse to decompose an adhesive (ADH) with which the components (CMP) are adhered to the component carrier surface (3s) .

15. The deposition device (1) according to claim 8, wherein the resistive heater layer (31) comprises a plurality of individually addressable sections for heating respective areal portions of the component carrier surface.

16. The deposition device (1) according to any of the preceding claims, wherein the component carrier has carrier fingers (3a, 3b,...3n) that are fixed at a first end and that have a free second end opposite the first end, which carrier fingers are laterally separated from each other by a gap.

17. A method of depositing components (CMP) on a substrate (STR), comprising:
providing a component carrier (3), having a component carrier surface (3s);
adhering (S1A, SIB, SIC) the components (CMP) on the component carrier surface (3s);
arranging (S2) the substrate (STR) on a substrate support surface (2s) of a substrate holder (2), with the substrate support surface (2s) facing the component carrier surface (3s);
resistively heating (S3A) the component carrier to induce a thermal expansion therein to move the component carrier surface (3s) towards the substrate support surface;
cooling or allowing the component carrier to cool (S4) to cause the component carrier (3) to move away from the from the substrate holder (2).

18. The method according to claim 17, wherein adhering (S1) the components (CMP) on the component carrier surface (3s) of the component carrier (3) comprises:
providing (S1A) a specimen of a thermally curable/processable/sensitive adhesive (ADH) to the component carrier surface (3s) of the component carrier (3);
resistively heating (S 1B) the component carrier with a deflection pulse (Pd) to thermally induce a deformation thereof, the component carrier therewith bending with its component carrier surface (3s) towards a supply substrate (SBC) with components thereon;
subsequently resistively heating (SIC) the component carrier with a gluing pulse (Pg), wherein the gluing pulse causes a further temperature increase for thermally processing the adhesive for adhering the components to the surface of the component carrier.

19. The method according to claim 17 or 18, wherein subsequent to resistively heating (S3A) the component carrier to cause the component carrier to bend with its component carrier surface (3s) towards the substrate support surface (2s), the component carrier is restively heated further (S3B) to increase its temperature further to form a liquid phase of a substance for bonding the components (CMP) to bond pads (PB) on the substrate (STR).

20. The method according to claim 19, wherein subsequent to said bonding (S3B) the component carrier surface is resistively heated further (S3C) with a decomposition pulse to increase its temperature to decompose an adhesive (ADH) used for adhering the components (CMP) on the component carrier surface (3s).

21. The method according to any of claims 17 to 20, comprising:
applying a further adhesive to a surface of a component to be removed from the substrate or to an area of the component carrier surface facing the component to be removed, wherein the further adhesive has a melting temperature exceeding that of an adhesive and/or solder with which said component is bonded to the substrate;
supplying an electric power to the resistive heating layer to therewith subsequently move the component carrier surface towards said component and to provide a transfer of heat that causes melting of the adhesive and/or solder with which said component is bonded to the substrate, and melting of the further adhesive;
stopping with supplying the electric power and causing therewith the further adhesive to cool down and cure and causing the component carrier surface with said component adhered thereto with the cured further adhesive to retract from the substrate before the adhesive and/or solder with which said component was bonded to the substrate cures or solidifies.
